# EUROPEAN PATENT APPLICATION

(11) **EP 2 518 760 A1**
(43) Date of publication of application: **31.10.2012**
(21) Application number: 10838921.4
(22) Date of filing: 17.12.2010
(51) Int. Cl.: H01L 21/60

(54) **AIR TENSION APPARATUS**

(30) Priority: 25.12.2009 JP 2009293838
(71) Applicant: Adamant Kogyo Co., Ltd., Tokyo 123-8595 (JP)
(72) Inventor: MIZOGUCHI, Hidetaka, Tokyo 123-8595 (JP); SAITO, Toshio, Yokote-shi Akita 013-0053 (JP); TERUI, Hiromi, Yokote-shi Akita 013-0053 (JP)
(74) Representative: Albiger, Jonas
(86) International application number: PCT/JP2010/007330
(87) International publication number: WO 2011/077681

(57) **Abstract**

Disclosed is an air tension device, comprising a through tube (4), further comprising a through aperture (3), wherethrough a metallic wire-bonding wire (2) is capable of passing; a support body (6) whereupon the through tube (4) is inserted, and which thereby supports the through tube (4); and a pressurized gas supply apparatus (7), which supplies pressurized gas to the through aperture (3) via a gas channel (18) that is disposed upon the through tube (4). The through aperture (3) is formed from a first through aperture (10), and a second through aperture (11), which is positioned below the first through aperture (10) and further comprised a narrow aperture portion (17) that has a smaller diameter than first through aperture (10). The diameter of the narrow aperture portion (17) is 0.070-0.100 mm, and is formed such that the ratio of the diameter of the first through aperture (10) to the diameter of the narrow aperture portion(17) is greater than or equal to 3.00 and less than 6.00. The apparatus thus avoids damaging the metallic wire (2) and applies a prescribed appropriate tension thereupon.

## Description

### TECHNICAL FIELD

The present invention relates to an air tension apparatus to be used to a wire bonding apparatus for connecting a wire to a semiconductor chip.

### BACKGROUND OF THE INVENTION

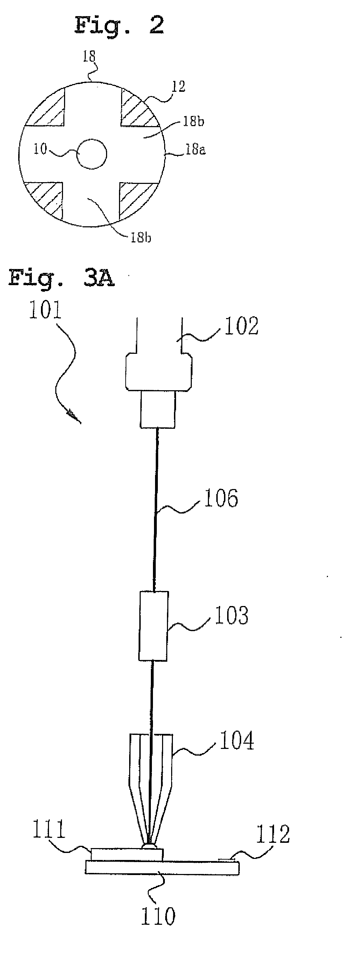

A wire bonding apparatus is hitherto known as an apparatus for connecting between a terminal of a semiconductor chip mounted on a circuit board and the lead of a circuit board by a metal wire. As shown in Fig. 3A to Fig. 3C, the wire bonding apparatus 101 is comprised of an air tension apparatus 102, a clamper 103 and a capillary 104. A metal wire 106 is arranged to be wound on a spool which is not shown in a drawing, and an end of the metal wire 106 which is pulled out from the spool is passed through through holes which is not shown in the drawings, but is provided on the air tension apparatus 102, the clamper 103 and capillary 104, is positioned at a tip portion of the capillary 104.

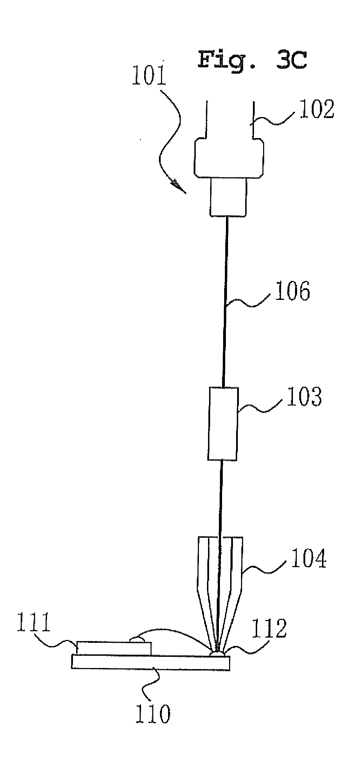

The clamper 103 and the capillary 104 is constituted to move vertically together. In a case that a bonding operation is conducted by the wire bonding apparatus 101 (hereinafter called merely as apparatus 101), firstly the clamper 103 and the capillary 104 are moved down. At this stage, the metal wire a 106 is clamped by a nip portion of the clamper 103 which is not shown in the drawings, and the metal wire 106 is pulled out a predetermined length from the spool at the same time when the clamper 103 movies down. And as shown in Fig. 3A, the apparatus 101 performs to bond the metal wire106 to the terminal of a semiconductor chip 111 disposed on a lead frame 110.
Subsequently, the apparatus 101 moves up the clamper 103 and the capillary 104 to the predetermine position as shown in Fig. 4B after the nip portion of the clamper 103 releases the metal wire 106 from nipping thereof.
Then, a table on which the lead frame 110 is mounted, and which is not shown in the drawings, is moved horizontally, and as shown in Fig 3C, a lead 112 on the lead frame 110 is positioned under the capillary 104. And then, at a condition that the metal wire 106 is nipped with the nipping portion of the clamper 103, the clamper 103 and the capillary 104 are moved downward, and the metal wire 106 is bonded on the lead 112.
After bonding work to the lead 112, the metal wire 106 is cut by rubbing the lead by the tip of the capillary 104, and the clamper 103 and the capillary 104 are elevated to return the predetermined position, and the bonding operation is concluded.

It is often the case that a plurality of metal wires 106 is bonded against one semiconductor chip 111, and in this case, the apparatus 101 repeats the steps described above to bond the metal wire on by one. Accordingly, the clamper 103 and the capillary 104 repeat the up-and-down movement, and the metal wire 106 is pulled out from the spool step by step. As a result, during the bonding operation, the metal wire 106 slackens, and the slackened metal wires 106 adjacently bonded between semiconductor chip 111 and the lead 112 may contact each other, and may possibly make a short circuit.

In order to prevent the metal wire 106 from slackening thereof, the metal wire 106 is always pulled in the direction of the air tension apparatus 102 by the air tension apparatus 102. By this operation, the metal wire 106 is bonded to the semiconductor chip 111 and the lead 112 in the condition that the slack does not occur, but it is necessary to eliminate the slack of the metal wire between the semiconductor chip 111 and the lead 112 after the bonding work, and to resolve problems of contacting the metal wire 106 each other due caused by the continuously bonding work.

The air tension apparatus is constructed to apply the predetermined tension to the metal wire, by passing the metal wire into the through hole of a cylindrical member usually called as a tension generation tube, and by flowing the air in the through hole. As examples of such an air tension apparatus, for instance, there are precedents, and one is an apparatus to apply the predetermined tension to the metal wire by flowing the air in the through hole due to a vacuum evacuation operating (called as vacuum type apparatus, hereinafter) (Patent Document 1), and the other is an apparatus to apply the predetermined tension to the metal wire by flowing the compressed air at the predetermined pressure in the through hole (called as pressurized type apparatus).
As the pressurized type apparatus, it is known that the relationship between the total length (L) of the through tube and the diameter (d) of the through tube is set to a formula of 30 ≦ (L/d) ≦ 200.

### CITATION LIST

### PATENT DOCUMENTS

Patent documents 1: Japanese Utility Mode Publication No. Hei 2 (1990)-7468,
Patent documents 2: Japanese Patent No. 3503700

### SUMMARY OF THE INVENTION

### Problems to be Solved by the Invention

In the vacuum type apparatus described in the Patent document 1, the tension is applied to the metal wire in the through hole since the air in the lower portion of the through hole is flowed to a reverse direction against the metal wire pulling out direction by vacuuming the air in the through hole, however, the tension applied to the metal wire in the through hole is small in comparison with the pressurized type apparatus, and it is feared that metal wire may be slackened by alternation of the sucking force.

And, in the pressurized type apparatus, it is possible to apply the tension larger than the tension of the vacuum type apparatus, since the compressed air which is added the predetermined pressure is supplied in the through hole in the reverse direction against the direction pulling out the metal wire. However, in the pressurized type apparatus of the Patent document 2, if the total length of the through hole is not extended more, or the diameter of the through hole is not made smaller, the tension applied to the metal wire cannot be increased.
However, as the through hole of the through tube, the diameter of the through hole which is used is about 100 *µ*m, and even though the diameter of the through hole is made more smaller, there are problems that it is difficult to increase greatly the tension. Accordingly, in order to increase the tension applied to the metal wire in the pressurized type apparatus, the total length must be extended, in such occasion, another problems that the air tension apparatus will be grown in size. The tip of the tension generation tube of the Patent document 2 is formed in taper shape opposite to the air supply hole from the lateral direction, therefore, the air blown from the air supply hole flows the bonding wire pull out direction (downward) from the tapered surface, and then the air flows to the air flow hole in the side of the tension generation tube 5, namely, the air flow becomes ascending current in the direction opposite to the direction of pulling out the bonding wire. Accordingly, at the tapered tip portion, the load is added to the bonding wire at the tapered tip portion, and is in danger of damage thereof by the blowing air downward current along the tapered surface, and the inverse function of the air in the reverse direction, i.e., in the upward direction.

Moreover, during the recent years, it is desired to use the metal wire which has smaller diameter, than the diameter of the conventional metal wire. In general, there are problems that a in a case that the diameter of the hole of the through tube, when the diameter of the metal wire becomes smaller, the tension applied to the metal wire become smaller. Therefore, in the pressurized type apparatus described in the Patent document 2, there are problems that it must extent the total length of the through tube, and the tension must be applied to the metal wire, as the results the apparatus will be grown in side.

In addition, it is possible to increase the tension applied to the metal wire by adjusting the flow rate of the compressed air to be flowed in the through tube, but in this way, it is difficult to apply appropriately the tension due to the flow fluctuation flowing in the through tube, and in accordance with the circumstances, there are problems that the metal wire has fear to be cut, since the tension applied to the metal wire will be greatly changed due to the flow fluctuation of the compressed air flowing in the through tube.

The present invention was attained with views of such problems stated above, and an object of the invention is to provide an air tension apparatus which is able to apply appropriate tension without any damages to the metal wire which has small diameter in more small flow rate of the air, and it is possible to very easily adjust the tension with facility.

### Means to solve the problems

The present invention is devised to have the following essentials, and the present invention is:
(1) An air tension apparatus comprising:
   through tubes having respectively an through hole which enable to pass a metal wire for wire bonding therethrough; a supporting member for fittingly supporting the through tubes; an air introduction path formed toward the through hole; and a compressed air supply apparatus having an opening to supply compressed air to the through hole via the air introduction path,
   wherein the through hole being comprised of a first insertion hole, and a second insertion hole which is communicated to the first insertion hole and has a narrow hole portion having a diameter smaller than a diameter of the first insertion hole,
   the diameter of the narrow hole portion is formed to have 0.100 to 0.070 mm, and the ratio of diameter of the first insertion hole against the diameter of the narrow hole portion is 3.00 or more to 6.00 or less, the compression air is prevented from direct blowing to a side portion of t wire bonding metal wire, and the metal wire is applied tension by the compressed air flowing from the first insertion hole which has a large diameter than the diameter of the narrow hole portion of the second insertion hole.
(2) The air tension apparatus according to (1) stated above, wherein the first insertion hole and the second insertion holes are aligned and is communicated therebetween.
(3) The air tension apparatus according to (1) stated above, wherein a passage of the air introduction path is formed as a cross shape against the through hole of the through tube.
(4) The air tension apparatus according to (1) stated above, further comprising an air chamber defined by the through tube and the supporting member, and the opening of the compressed air supply apparatus which communicates to the air chamber is provided at the portion shifted from the opening of the air introduction path, pressure of the compressed flowing air is against the metal wire is equalized, and the metal wire is prevented from damaging and predetermined tension is applied to the metal wire.

### Effects of the Invention

In the present invention of an air tension apparatus, an through hole is formed to insert a metal wire, and to be difficult to flow the compressed air into the second insertion hole, and to be easily flow in the first insertion hole such that a diameter of a narrow hole portion of a second insertion hole of a lower through tube aligned in a direction of the axis of a first insertion hole of an upper through tube is formed to have 0.100 to 0.070 mm, and the ratio of diameter of the first insertion hole against the diameter of the narrow hole portion is 3.00 or more to 6.00 or less, accordingly, the almost compressed air supplied from a compress air supply apparatus is able to be flowed in the first insertion hole. At this time, since the compressed air flows in the first insertion hole in the direction of a source of supply of the metal wire, large tension is able to be applied to the metal wire which has more small diameter in addition to the the metal wire which has the same diameter of the traditional metal wire.
As stated above, the present invention is able to apply the appropriate tension to the metal wire which has more small diameter, the metal wire does not slacken nor loosen, accordingly, it is able to prevent from contacting the adjacent metal wires, and to present from reducing in quality of a circuit board.

### BRIEF DESCRIPTION OF THE DRAW2INGS

Fig. 1 is a vertical cross-sectional view showing an embodiment of an air tension apparatus of the present invention;
Fig. 2 is a horizontally cross-sectional showing a structure of an air introduction path;
Fig. 3A is a schematic side view showing an example of a wire bonding step;
Fig. 3B is a schematic side view showing an example of a wire bonding step;

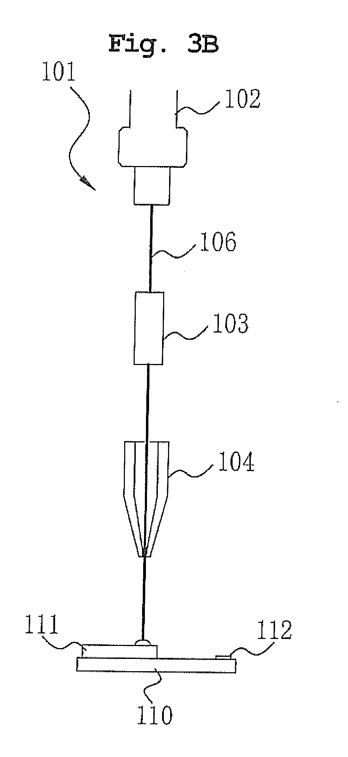

Fig. 3Cis a schematic side view showing an example of a wire bonding step.

### DESCRIPTION OF THE PREFERRED EMBODIMENT

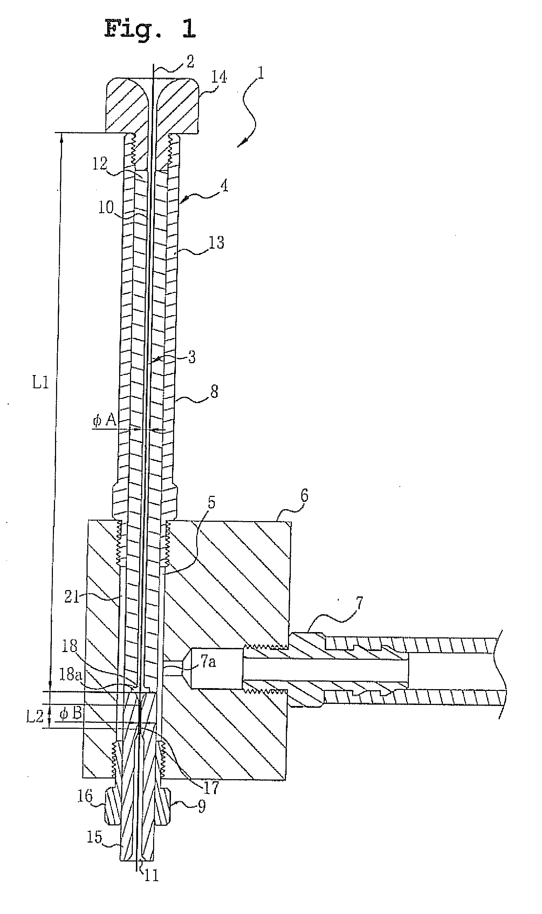

As shown in Fig. 1, an air tension apparatus 1 of the present invention is comprised of an through tube 4which has an through hole 3 to insert a metal wire therethrough, and the through tube 4 is inserted in a through hole 5 of a supporting structure 6 and supported thereby. And, the supporting structure 6 has a compression air supplying portion 7 as a compression air supplying apparatus to supply compressed air or gas to the through hole 3. Each structure will be explained below.
In addition, the metal wire 2 is used a gold wire which has generally a diameter of 20 *µ*m to 40 *µ*m, however, the metal wire is not limited to this instance and another metal wire which has a diameter without of 20 *µ*m to 40 *µ*m is used. Moreover, the raw material of the wire is not limited to the gold, and the wire which is made from aluminum , copper or an alloy having main ingredients of these materials is used.
Moreover, upper and lower directions and right and left directions defined in this specification show the upper and lower directions and the right and left directions referred to the air tension apparatus in Fig. 1.

As shown in Fig. 1, the through tube 4 is comprised of an upper through tube 8 and a lower through tube 9, the through hole 3 is comprised of a first insertion hole 10 provided with the upper through upper 8 and a second insertion hole 11 provided with the lower through tube 9. With regard to the upper through tube 8, an upper through tube main unit 12 which has the first insertion hole 10 is fitted within an upper sleeve 13. Moreover, with regard to the lower through tube 9, a lower through tube main unit 15 which has the second insertion hole 11 is fitted and secured within a lower sleeve 16.

The first insertion hole 10 and the second insertion hole 11 are holes which have a diameter being enable the metal wire 2 to pass by insertion into the holes .The first insertion hole 10 and the second insertion hole 11 are formed to be aligned central axes thereof when the upper through tube 8 and the lower through tube 9 are assembled in the through hole 5. And, a narrow hole portion is formed at an upper portion of the second insertion hole 11. The narrow hole portion is formed to have a diameter which is narrower than a diameter of the second insertion hole 11 (without the narrow hole portion 17). The diameter of the hole is prefer to be formed between 0.100 to 0.70 mm, and is appropriate have 0.090 to 0.080 mm from the point of view being added the tension to the metal wire 2.

As shown in Fig 1, the narrow hole portion 17 in relation to the first insertion hole 10 is formed such that, when a hole diameter (inside diameter) of the first insertion hole 10 is identified as *φ*A, and a hole diameter (inside diameter) of the narrow hole portion 17 is identified as a *φ*B, the ratio (*φ*A/*φ*B) of a hole diameter(*φ* B) of the narrow through hole portion 17 against the hole diameter (*φ*A) of the first insertion hole 10 become 3.00 or more to 6.00 or less. When the ratio is 3.00 or less, the inside diameter of the narrow hole portion become lager, and the compressed air will easily flow to the second insertion hole 11 in addition to the second insertion hole 11, and it will be difficult to apply a predetermined tension to the metal wire with the small flow rate of the air. On the other hand, when the ratio is 6.00 or or more, it will become hard to flow the compressed air to the second insertion hole 11, and excessive tension will be applied to the metal wire 2, so that it is undesirable.
And, the value of the ratio mentioned above is more preferable to be in the ratio of between 3.00 or more and 5.00 or less from the point of view of easy operation when the metal wire 2 is set or tension is applied to the metal wire 2 at the time of a wire bonding operation.
Moreover, it is preferable to provide the first insertion hole 10 and the narrow hole portion 17 so as to align in a direction the axes thereof and to communicate therebetween.

Moreover, an air introduction path 18 which has a plurality of passages 18b is formed at a lower end surface of a upper through tube main unit 12 to introduce the compressed air into the through hole 3. The air introduction path 18 is formed in a cross shape in a planar view as shown in Fig. 2.
And, it is adequate that the air introduction path 18 enables to conduct to the above mentioned objectives and purposes, the shape of the air introduction path 18 is not limited to the cross shape, and the passages of the air introduction path can be spaced 120 degrees therebetween. In order not to blow the compressed air of the compressed air supply apparatus to the metal wire in the horizontal direction, it is adequate that the compressed air is introduced into the through hole 3 via the plurality of passages 18b preventing from blowing directly the compressed air of the compressed air supply apparatus to side portions of the metal wire 2 from the lateral direction, and it is possible to provide the air introduction path 18 at any portion excepting a lower end surface of the upper through tube main unit 12. For example, it is possible to provide a hole an introduction pass from and through an outer surface of the upper through tube main unit 12 to the through hole 3.

An inner diameter of the through hole 5 is formed to have large diameter than an each outer diameter of the upper through tube main unit 12 and of the lower through tube main unit 15. At an upper end portion of the through hole 5, the upper through tube 8 is secured by a screw means, and at a lower end portion of the through hole 5, it is formed to secure the lower through tube 8 by a screw means. When the upper through tube 8 and the lower through tube9 are mounted to the supporting body or member 6, a space, i.e. air chamber 21 is defined and provided by at least inner periphery of the through hole 5 and respective outer peripheries of the upper through tube main unit 12 and the lower through tube main unit 15 between the through hole 5, the upper through tube main unit 12 and the lower through tube main unit 15.

An opening 7a of the compressed air supply apparatus 7 is communicated to the air chamber 21, and as one example, the opening 7a is formed at a portion shifted to an upper portion than an opening 8a of the air introduction path 18 to have a structure to flow the compressed air into the plurality of air introduction path 18, so the opening of the compressed air supply apparatus is formed at the portion not to occur excessive operating stress of the metal wire 2, and so as not be directly blown the compressed air from the compressed air supply apparatus to it.
In addition, it is adequate that the compressed air supply apparatus 7 is provided at a portion that the excessive operating stress does not occur to the metal wire 2, and is provided at a portion sifted to lower portion from the opening 18a of the air introduction path 18. And, even though the opening 7a of the compressed air supply apparatus 7 and the opening 8a of the air introduction path 18 are provided at the same height, the pressure of the compressed air will not be directly applied to the metal wire 2 in a case that the opening 7a does not directly opposite to the metal wire 2, and the both the openings 7a and 18a are provided at the shifted portion.

It is preferable that the internal diameter of the first insertion hole 10 is 0.300 mm to 0.600 mm, and it is more preferable that the inner diameter thereof is 0.300 to 0.400 mm. In the case that the inner diameter is 0.300 mm or less, in the relation with the outer diameter of the metal wire 2, the variation of the flux of the compresses air influence on the variation of the tension added to the metal wire 2, and it will greatly increase the risk to cut off the metal wire 2. On the other hand, in a case that the inner diameter thereof is 0.600 mm or more, sudden change of the tension applied to the metal wire 2 will decreases, but the tension applied to the metal wire 2 will become lower exceedingly, and the flux of the compressed air must be increased, so it will be difficult to adjust the tension applied to the metal wire 2.

It is preferable to use materials such as ceramic s or the like for the upper through tube main unit 12 and the lower through tube main unit 15 in consideration of the strength or hardness of the through tube, and of points that prevent from generation of conductible dirt or dust which will become causal for shortage of the interconnection thereof. And, it is preferable to use materials such as stainless steel from the point of views of workability or strength for the upper sleeve 13 and the lower sleeve 16, however it is possible to use appropriately the materials which enable the upper through tube main unit 12 and the lower through tube main unit 15 to be mounted and secured on the supporting body 6.

Also, in the above stated embodiment, the upper through tube main unit 12 is fitted pressingly into the upper sleeve 13 and the lower through tube main unit 15 is fitted pressingly into the lower sleeve 15. However, it is possible to use appropriately any other ways for securing the sleeves and the through tube main units, or it is possible to use an integrated aggregate of the sleeves and the through tube unites.

Then, operation of the air tension apparatus of the present invention will be explained. The air tension apparatus of the present invention is formed such that the ratio (øA/øB) of the hole diameter(øB) of the narrow through hole portion 17 of the second through hole 11against the hole diameter (øA) of the first insertion hole 10 become 3.00 or more to 6.00 or less, accordingly it is difficult to flow the compressed air into the second insertion hole 11the compressed air, and it is easily flow the compressed air into the first insertion hole 10, and it is possible to make differences of the flow rates between the flow volume of the compressed air flowing into the first insertion hole10and the flow volume of the compressed air flowing into the second insertion hole 11.

In other words, almost of all the compressed air to be supplied into the through hole 5 from the air introduction path18 via the compressed air supply apparatus 7 from an air supply apparatus which is not shown in the drawings, flows into the first insertion hole 10 formed large diameter than the hole diameter of the narrow hole portion 17. At this time, since the compressed air flows upward from the lower end of the first insertion hole 10 to the direction of the upper end thereof in the direction of a supply source supplying the metal wire, it is possible to apply tension to the metal wire 2 by the compressed air.

Since the sir tension application1 shown in Fig. 1 is defined by the inner periphery of at least the through hole 5, each outer periphery of the upper through tube 8 and of the lower through tube 9, and a space formed therebetween, namely the air chamber 21 is formed within the through hole 5, the compressed air supplied from the compressed air supply apparatus 7 flows into the first insertion hole 10 and the second insertion hole 11 after once flowing into the air chamber 21. Accordingly, when pressure fluctuation occurs on the compressed air supplied from the air supplying apparatus which is not shown in the drawings, it is possible to reduce influences of the pressure fluctuation by flowing the compressed air once into the air chamber 21 which operates as a buffer tank, and it is possible usually to supply the compressed air in the pressure equalization becomes possible. Accordingly, it is possible to prevent from cutting or damaging the metal wire 2 due to being affected by influence of sudden change of the tension by the pressure fluctuation.

Moreover, in the air tension apparatus described above, the cross shaped air introduction path 18 provided in the horizontal direction crossing the first insertion hole 10 and the opening 7a are vertically shifted, and are communicated therebetween, not so as to blow directly the compressed air supplied supplied from the the compressed air supply apparatus to the metal wire 2 inserted in the upper through tube main unit 12 from the horizontal direction. Accordingly, the compressed in the air chamber 21 flows into the air introduction path18 from the four openings 18a, i.e. from the four directions after going around the upper through tube main unit 12 in the air chamber 21. The compressed air is mingled at a portion crossing the air introduction path 18, and the flow is dispersed and the compressed air in the pressure equalization state enables to flow in the longitudinal direction upward to the center axis of the first insertion hole 10. Accordingly, it is possible to effectively feed the compressed air in the first insertion hole 10. Moreover, as other embodiments, since the opening of the compressed air supply apparatus can be opened to the air chamber corresponding the outer wall between the air introduction path of the upper through tube main unit 12, by this formation, the opening and the air introduction path do not directly oppose thereto, and the compressed air blown from the compressed air supply apparatus blows against the outer wall and simultaneously blows around in the air chamber and flows in the openings of the air introduction path at the equivalent air pressure, the compressed air from the compressed air supply apparatus prevents from directly blowing to the side portion of the metal wire 2 via the air chamber. It is possible to accomplish the equalization of pressure of the compressed flowing air against the metal wire 2, and to prevent from damaging the metal wire 2, and to apply the predetermined appropriate tension thereto.

Moreover, as shown in Fig. 1, in the air tension apparatus 1 of the embodiment, since t the opening7a of the compressed air supply apparatus 7and the opening 18a of the air introduction path 18 are respectively provided at the shifted portions therebetween, the compressed air is not directly supplied in a blowing state to the metal wire 2 from the compressed air supply apparatus, therefore the excessive stress is not applied to the metal wire 2, and the situations such as cutting or the like of the metal wire 2 is surely prevented.

### Example 1:

The present invention is explained in detail in accordance with a specific example, however, the present invention is not limited to this example.
In the apparatus shown in Fig. 1, two upper through tubes are prepared and which the first through hole has respectively an inner diameter (øA) of 0.300 mm and 0.400 mm , and six lower through tubes are prepared and which the narrow hole portion has the inner diameter (øB) of 0.080 mm, 0.090 mm, 0.100 mm, 0.110 mm, 0.120 mm and 0.130 mm. In a case that the inner diameter (øA) of 0.300 mm of the first through hole is used, the inner diameter of the first through hole to the narrow hole portion ratio of (øA) /(øB) is respectively 3.75, 3.33, 3.00, 2,73, 2.50 and 2.31. And, in a case that the inner diameter (øA) of 0.400 mm of the first through hole is used, the ratio thereof is respectively 5.00, 4.44, 4.00, 3.64, 3.33 and 3.08. And, the entire length (L1) of 30.0 mm of the upper through tube main unit, and the entire length (L2) of 1.50 mm of the lower through tube unit are used.
And thereafter, the inner diameter (øB) of the narrow hole portion is 0. Moreover, a gold wire which has a diameter of 20 µm selected from several metal wires is used as the metal wire to be inserted through the first through hole and the narrow hole. The gold wire is supplied from the upper end surface of the upper through tube and is extended from the lower end surface of the lower through tube. The gold wire extended from the lower end surface of the lower through tube is passed within 1 clamper and a capillary, and is extended from a tip of the capillary.
As the compressed air, the compressed air which has a primary pressure of 0.5MPa is adjusted by a flow regulating valve, and the compressed air which is adjusted to a flow rate 11/min at the secondary side is supplied to the air tension apparatus. Also, the flow volume at the secondary side is measured by a mass flow meter provided at a downstream of the flow regulating valve.

### (Method for Inspection)

In the inspection, firstly the upper through tube main unit which has the first through hole of the inner diameter (øA) of 0.300 mm, and the lower through tube maim unit which has the narrow hole portion of the inner diameter (øB) of 0.080 mm are used, and wire bonding operation is conducted to ten semiconductor chips, each of which is square, 3 mm on a side, and 50 times wire bonding operations are conducted on each of the semiconductor chips, and confirmation works are conducted by an optical microscope of 20 magnifying to found occurrence of slack which will cause defect on the bonded gold wire. In the inspection, the bonded chip which has 3 or less slacks of the gold wire during 10 semiconductor chips is determined on pass of the inspection, and the bonded chip which has 4 or more slacks thereof is determined as failure to meet inspection. By the same method, the inspection is conducted on the combination with the lower through tube main units having respective inner diameter of 0.90 mm, 0.100 mm, 0.110 mm, 0.120 mm and 0.130 mm. And then, the upper through tube main unit which has the first insertion hole of the inner diameter (øA) of 0.400 mm is used, and an inspection is conducted by the same method mentioned above, pass-fail determination is carried out.

From the results of the inspection, the upper through tube main unit which has either of the inner diameter (øA) of 0.300 mm or 0.400 mm of the first through hole is used, and the narrow hole portion of the lower through tube main unit which has either of the inner diameter (øB) of 0.080 mm, 0.090 mm and 0.100 mm is used, and in the case that the first insertion hole of the inner diameter (øA) of 0.300 mm is used, and the inner diameter of the first insertion hole to the inner diameter of the narrow hole portion ratio of (øA) /(øB) is respectively 3.75, 3.33, 3.00, and the first insertion hole of the inner diameter (øA) of 0.400 mm is used and the inner diameter of the first insertion hole to the inner diameter of the narrow hole portion ratio is respectively 5.00, 4.44 and 4.00, the number of slack, which may become a cause for defect, occurred on the gold wire is 0 to 2 with regard to 10 semiconductor chips, and all of the chips are determined as pass in the inspection..
From the result mentioned above, it is found that it is possible to resolve the slack on the gold wire by that the inner diameter of the narrow hole portion of the lower through tube main unit is 0.100 mm to 0.070 mm, and simultaneously the above stated value of the ratio is given between 3.00 to 6.00.

## Claims

1. An air tension apparatus comprising:
through tubes having respectively an through hole which enable to pass a metal wire for wire bonding therethrough;
a supporting member for fittingly supporting the through tubes;
an air introduction path formed toward the through hole; and
a compressed air supply apparatus having an opening to supply compressed air to the through hole via the air introduction path,
wherein the through hole being comprised of a first insertion hole, and a second insertion hole which is communicated to the first insertion hole and has a narrow hole portion having a diameter smaller than a diameter of the first insertion hole,
the diameter of the narrow hole portion is formed to have 0.100 to 0.070 mm, and the ratio of diameter of the first insertion hole against the diameter of the narrow hole portion is 3.00 or more to 6.00 or less, the compression air is prevented from direct blowing to a side portion of t wire bonding metal wire, and the metal wire is applied tension by the compressed air flowing from the first insertion hole which has a large diameter than the diameter of the narrow hole portion of the second insertion hole.

2. The air tension apparatus according to claim 1, wherein the first insertion hole and the second insertion holes are aligned and is communicated therebetween.

3. The air tension apparatus according to claim 1, wherein a passage of the air introduction path is formed as a cross shape against the through hole of the through tube.

4. The air tension apparatus according to claim 1, further comprising an air chamber defined by the through tube and the supporting member, and the opening of the compressed air supply apparatus which communicates to the air chamber is provided at the portion shifted from the opening of the air introduction path, pressure of the compressed flowing air is against the metal wire is equalized, and the metal wire is prevented from damaging and predetermined tension is applied to the metal wire.

5. The air tension apparatus according to claim 1, wherein the air introduction path has a plurality of passages, the through tube is comprised of a first through tube and a second through tube, the first through tube has a first insertion hole, and the second through tube has a second insertion hole, and an air chamber is provided to communicate with the passages of the air introduction path defined by an outer surface of the first insertion hole, an outer surface of the second insertion hole and an inner periphery of the supporting member.

6. The air tension apparatus according to claim 5, wherein the opening of the compression air supply apparatus is opened to the air chamber positioned at an upper portion of the air introduction path.

7. The air tension apparatus according to claim 5, wherein the opening of the compression air supply apparatus is opened to the air chamber positioned at a lower portion of the air introduction path.

8. The air tension apparatus according to claim. 5, wherein the opening of the compression air supply apparatus is opened to the air chamber opposite to an outer wall of the first insertion hole between the passages of the air introduction path.

9. The air tension apparatus according to claim 8, wherein the compressed air from the compression air supply apparatus blows against the outer side wall of the first through tube, and the compressed air flows along wall portion in the air chamber and flows in the air introduction path, and the side wall formed between the plurality of the passages of the air introduction path prevents a side portion of the metal wire from direct blowing of the compressed air blowing via the air chamber from the compressed air supply apparatus.
